# EUROPEAN PATENT APPLICATION

(11) **EP 4 199 069 A1**
(43) Date of publication of application: **21.06.2023**
(21) Application number: 22213169.0
(22) Date of filing: 13.12.2022
(51) Int. Cl.: H01L 23/15, H01L 23/13, H01L 23/538

(54) **MICROELECTRONIC ASSEMBLIES WITH GLASS SUBSTRATES AND THIN FILM CAPACITORS**

(30) Priority: 16.12.2021 US 202117552581
(71) Applicant: INTEL Corporation, Santa Clara, CA 95054 (US)
(72) Inventor: PIETAMBARAM, Srinivas V., Chandler, 85249 (US); IBRAHIM, Tarek A., Mesa, 85203 (US); MANEPALLI, Rahul N., Chandler, 85249 (US); GUZEK, John, Chandler, 85248 (US); AZIMI, Hamid, Paradise Valley, 85253 (US)
(74) Representative: 2SPL Patentanwälte PartG mbB

(57) **Abstract**

Microelectronic assemblies, related devices and methods, are disclosed herein. In some embodiments, a microelectronic assembly may include a glass substrate, having a surface, including a through-glass-substrate via (TGV) and a cavity on the surface; a first die nested in the cavity; an insulating material on the surface of the glass substrate; a first conductive pillar and a second conductive pillar through the insulating material; a capacitor, in the insulating material, including a first conductive layer, on the surface of the glass substrate, electrically coupled to the TGV and the first conductive pillar forming a first plate of the capacitor, a dielectric layer on the first conductive layer; and a second conductive layer, on the dielectric layer, electrically coupled to the second conductive pillar forming a second plate of the capacitor; and a second die, on the insulating material, electrically coupled to the first die.

## Description

### Background

Integrated circuit (IC) packages may include capacitors for managing power delivery to IC dies. Typically, IC packages may include capacitors surface-mounted on a backside of a die or on a land side of a circuit board.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1A is a schematic side, cross-sectional view of an example microelectronic assembly, in accordance with various embodiments.
FIG. 1B is a schematic illustration of an example detail of a thin film capacitor of FIG. 1A, in accordance with various embodiments.
FIG. 2 is a schematic side, cross-sectional view of another example microelectronic assembly, in accordance with various embodiments.
FIGS. 3A-3N are side, cross-sectional views of various stages in an example process for manufacturing the example microelectronic assembly of FIG. 2, in accordance with various embodiments.
FIG. 4 is a side, cross-sectional view of an example microelectronic assembly, in accordance with various embodiments.
FIGS. 5A-5G are side, cross-sectional views of various stages in an example process for manufacturing the example microelectronic assembly of FIG. 4, in accordance with various embodiments.
FIG. 6 is a top view of a wafer and dies that may be included in a microelectronic assembly, in accordance with any of the embodiments disclosed herein.
FIG. 7 is a cross-sectional side view of an IC device that may be included in a microelectronic assembly, in accordance with any of the embodiments disclosed herein.
FIG. 8 is a cross-sectional side view of an IC device assembly that may include a microelectronic assembly, in accordance with any of the embodiments disclosed herein.
FIG. 9 is a block diagram of an example electrical device that may include a microelectronic assembly, in accordance with any of the embodiments disclosed herein.

### Detailed Description

Microelectronic assemblies, and related devices and methods, are disclosed herein. For example, in some embodiments, a microelectronic assembly may include a substrate having a first surface and an opposing second surface, wherein a material of the substrate includes glass, and wherein the substrate includes a conductive through-glass via (TGV), and the second surface of the substrate includes a cavity; a first die at least partially nested in the cavity; an insulating material, on the second surface of the substrate, the insulating material having a first surface and an opposing second surface, wherein the first surface of the insulating material is at the second surface of the substrate; a first conductive pillar through the insulating material; a second conductive pillar through the insulating material; a capacitor in the insulating material at the second surface of the substrate, the capacitor including: a first layer on the second surface of the substrate, the first layer including a conductive material electrically coupled to the TGV and the first conductive pillar, wherein the first layer forms a first plate of the capacitor; a second layer on the first layer, the second layer including a dielectric material; a third layer on the second layer, the second including the conductive material electrically coupled to the second conductive pillar, wherein the third layer forms a second plate of the capacitor; and a second die, at the second surface of the insulating material, electrically coupled to the first die.

Communicating large numbers of signals between two or more dies in a multi-die IC package is challenging due to the increasingly small size of such dies, thermal constraints, and power delivery constraints, among others. Typically, IC packages include prefabricated capacitors that may be surface-mounted on a die or a circuit board. For example, IC packages may include die side capacitors (DSC) mounted on a backside of a die or land side capacitors (LSC) mounted on a circuit board. Surface-mounted capacitors are likely to increase latency of power delivery due to increased power trace distance, occupy limited surface area on the die and/or circuit board, and increase overall z-height (e.g., thickness) of the IC package. One conventional solution for incorporating capacitors is to build metal-insulator-metal (MIM) capacitors in the top dies as part of the voltage regulator circuitry necessary for the power delivery function of the IC package, but many dies cannot incorporate a sufficient number of MIM capacitors to meet capacitance demands of the power delivery network. Another conventional solution is to incorporate capacitors in a package substrate, which results in long electrical pathways from the capacitor to the die. Various ones of the embodiments disclosed herein may help achieve improved power efficiency with greater design flexibility, relative to conventional approaches. Various ones of the microelectronic assemblies disclosed herein may exhibit better power delivery while reducing the size of the package relative to conventional approaches and increased capacitance density structures. The microelectronic assemblies disclosed herein may be particularly advantageous for power hungry applications (e.g., servers and high end laptops) where glass substrates may reduce warpage and enable large Form Factor Devices.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The drawings are not necessarily to scale. Although many of the drawings illustrate rectilinear structures with flat walls and right-angle corners, this is simply for ease of illustration, and actual devices made using these techniques will exhibit rounded corners, surface roughness, and other features.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, a "package" and an "IC package" are synonymous, as are a "die" and an "IC die." The terms "top" and "bottom" may be used herein to explain various features of the drawings, but these terms are simply for ease of discussion, and do not imply a desired or required orientation. As used herein, the term "insulating" means "electrically insulating," unless otherwise specified. Throughout the specification, and in the claims, the term "coupled" means a direct or indirect connection, such as a direct electrical, mechanical, or magnetic connection between the things that are connected or an indirect connection, through one or more passive or active intermediary devices. The meaning of "a," "an," and "the" include plural references. The meaning of "in" includes "in" and "on."

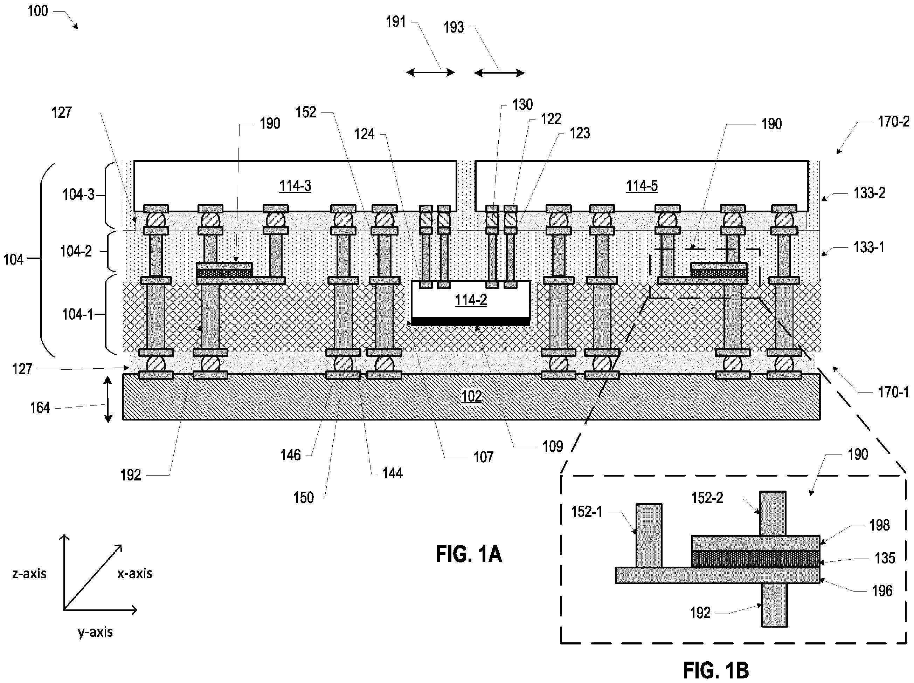

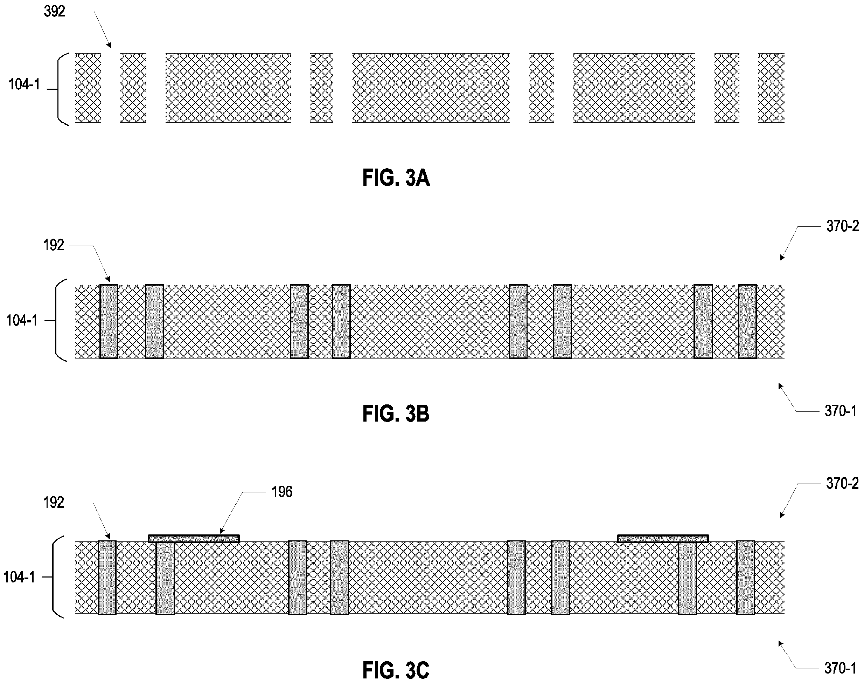

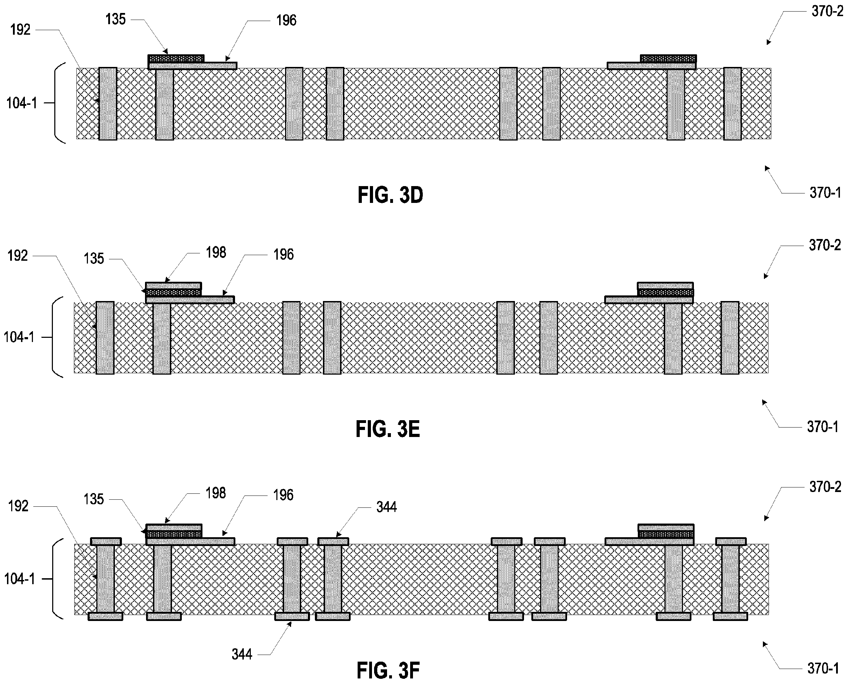

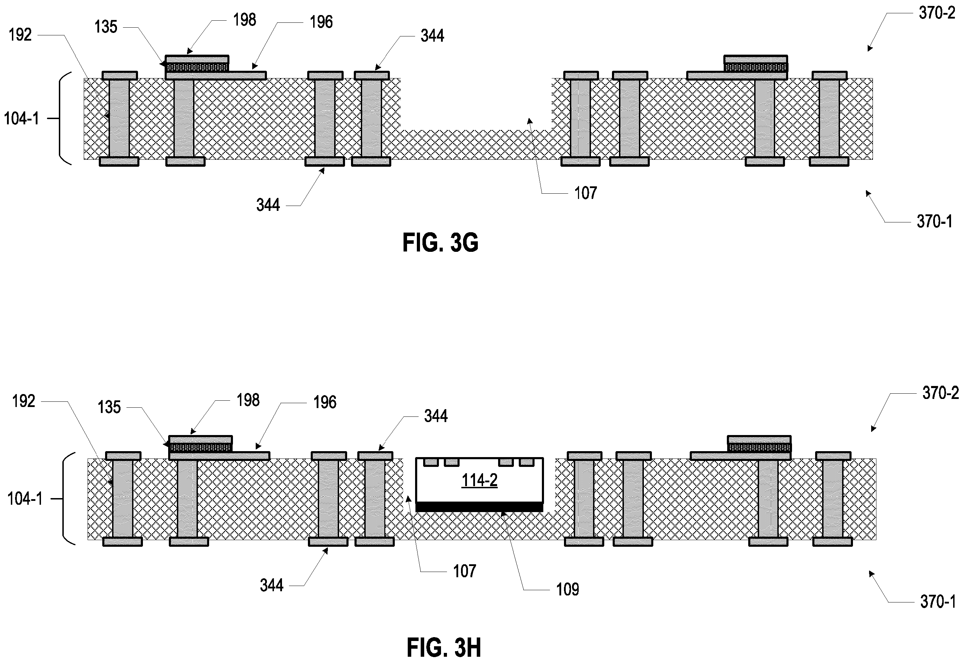

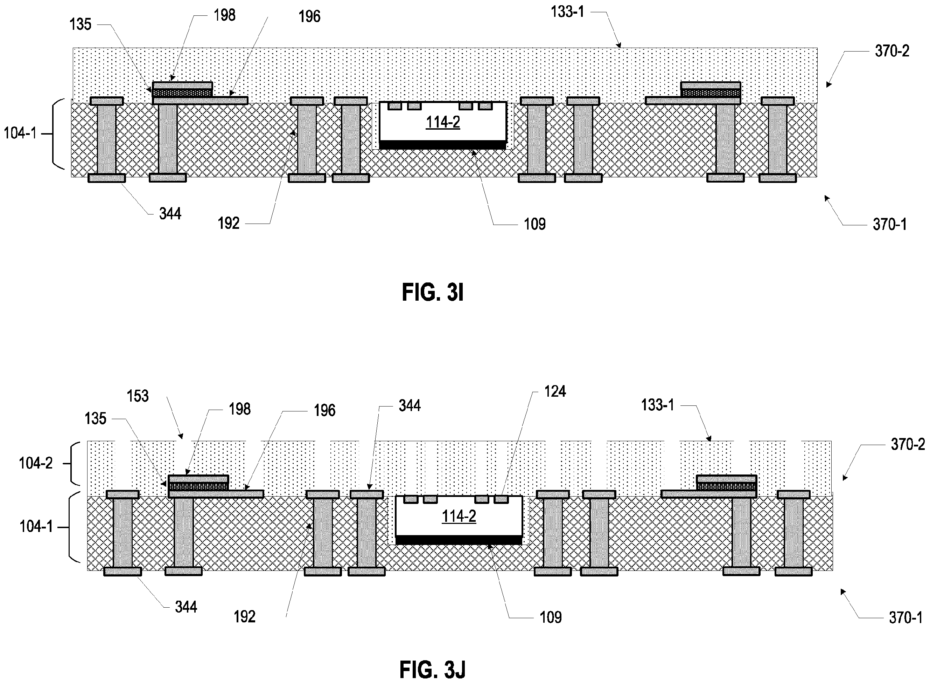

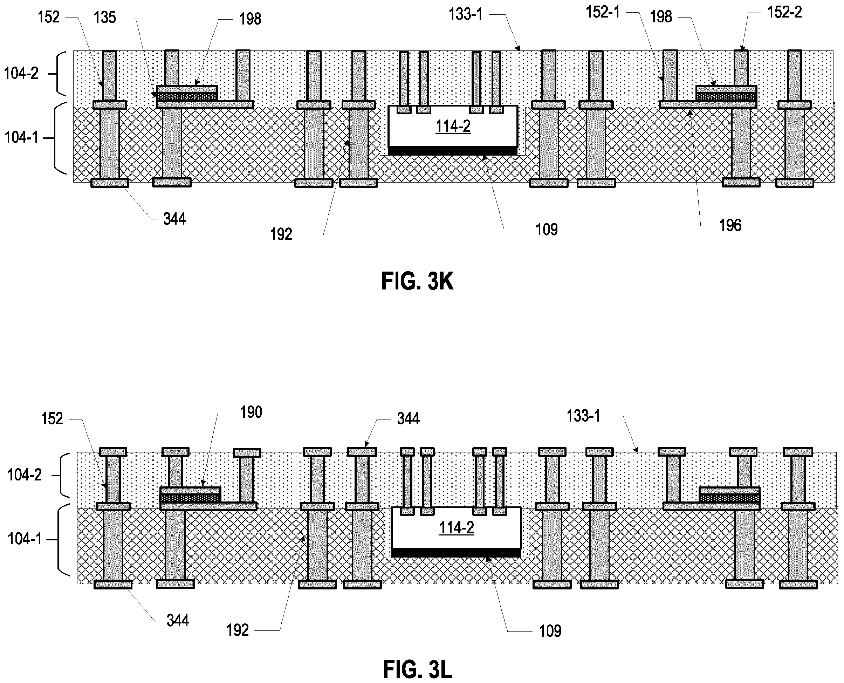

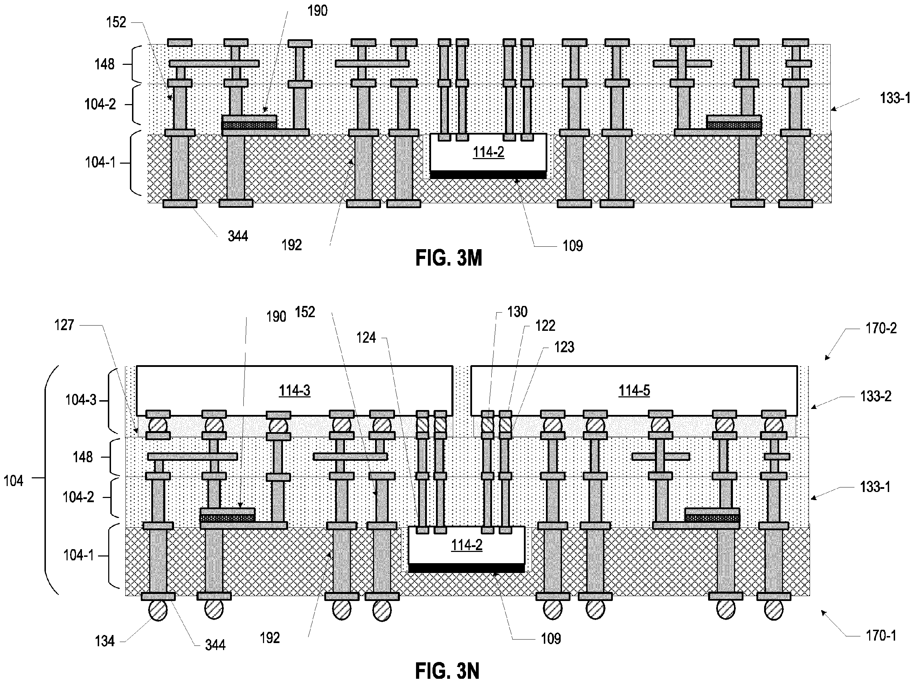

When used to describe a range of dimensions, the phrase "between X and Y" represents a range that includes X and Y. For convenience, the phrase "FIG. 1" may be used to refer to the collection of drawings of FIGS. 1A and 1B, the phrase "FIG. 3" may be used to refer to the collection of drawings of FIGS. 3A-3N, etc. Although certain elements may be referred to in the singular herein, such elements may include multiple sub-elements. For example, "an insulating material" may include one or more insulating materials. As used herein, a "conductive contact" may refer to a portion of conductive material (e.g., metal) serving as an electrical interface between different components; conductive contacts may be recessed in, flush with, or extending away from a surface of a component, and may take any suitable form (e.g., a conductive pad or socket, or portion of a conductive line or via).

FIG. 1A is a side, cross-sectional view of a microelectronic assembly 100, in accordance with various embodiments. The microelectronic assembly 100 may include a package substrate 102 coupled to a multi-layer die subassembly 104. As shown in FIG. 1A, the multi-layer die subassembly 104 may include three layers. In particular, the multi-layer die subassembly 104 may include a glass substrate 104-1 (i.e., a first layer) having a through-glass-substrate via ("TGV") 192 and a die 114-2, a second layer 104-2 having an integrated thin film MIM capacitor ("TFC") 190 and a conductive pillar 152, and a third layer 104-3 having a die 114-3 and a die 114-5. The multi-layer die subassembly 104 may have a first surface 170-1 and an opposing second surface 170-2. The glass substrate 104-1 may include a cavity 107 with an opening facing the second surface 170-2 and the die 114-2 may be nested, fully or at least partially, in the cavity 107. As shown in FIG. 1B, the TFC 190 may include a first capacitor plate 196 (e.g., a first conductive trace, a first conductive pad, or a first conductive layer that forms the first capacitor plate, also referred to herein as a bottom electrode), a second capacitor plate 198 (e.g., a second conductive trace, a second conductive pad, or a second conductive layer that forms the second capacitor plate, also referred to herein as a top electrode), and a dielectric material 135 between the first and second capacitor plates 196, 198. As used herein, the term "a conductive trace" also may be referred to as "a conductive line." The first capacitor plate 196 may be coupled to a TGV 192 and a first conductive pillar 152-1, and the second capacitor plate 198 may be coupled to a second conductive pillar 152-2 to form the TFC 190. The first and second capacitors plates 196, 198 may be coupled to other conductive pathways (e.g., conductive lines and conductive vias, not shown) in the second layer 104-2.

A multi-layer die subassembly 104 may have any suitable number of TFCs 190, including one or more. A TFC 190 may improve the performance of the microelectronic assembly 100 by more efficiently delivering power to the one or more dies 114. A TFC 190 may have any suitable dimensions. In some embodiments, the TFC 190 may have an overall thickness (e.g., z-height) between 35 nanometers and 2,000 nanometers. The TFC 190 may include any suitable materials. The first and second capacitor plates 196, 198 of the TFC 190 may be formed of any appropriate conductive material, such as copper, silver, nickel, gold, aluminum, or other metals or alloys, for example. The first and second capacitor plates 196, 198 may have any suitable dimensions, for example, the first capacitor plate 196 may have a thickness between 10 nanometers and 15 microns and the second capacitor plate 198 have a thickness between 10 nanometers and 15 microns. The first and second capacitor plates 196, 198 may be formed using any suitable process, including, for example, a semi-additive process (SAP), as described below with reference to FIG. 3. The dielectric material 135 of the TFC 190 may include an ultra-high-k dielectric material, typically in a crystalline state. Examples of suitable ultra-high-k dielectric materials include barium, titanium, and oxygen (e.g., in the form of barium titanium oxide); strontium, titanium, and oxygen (e.g., in the form of strontium titanate (STO)); titanium and oxygen (e.g., in the form of titanium oxide (TiOz)); lead, zirconium, and titanium (e.g., in the form of lead zirconate titanate (PZT)); barium, strontium, and titanium (e.g., in the form of barium strontium titanate (BST)); a ferroelectric material; and a ferroelectric perovskite material, among others. In some embodiments, a dielectric material 135 may include any material with a permittivity high enough to achieve a capacitance density between 10 nF/mm² and 10,000 nF/mm². In some embodiments, a relative permittivity of the dielectric material 135 may be between 50 and 10,000. In some other embodiments, a relative permittivity of the dielectric material 135 may be between 150 and 500. The dielectric material 135 may have any suitable dimensions, for example, a thickness of the dielectric material 135 may be between 10 nanometers and 250 nanometers. The dielectric material 135 may be formed using any suitable process, including, for example, thin film deposition or lamination, as described below with reference to FIG. 3. In some embodiments, the dielectric material 135 may be formed in multiple layers. The deposition of the dielectrics on a glass substrate enables the use of high quality high-k dielectric films which usually are deposited at temperatures up to 600 degrees Celsius or deposited at room temperature and annealed at a temperature between 500 degrees Celsius and 600 degrees Celsius.

As shown in FIG. 1A, the multi-layer die subassembly 104 may include a plurality of layers. A first layer 104-1 may include a glass substrate that provides mechanical stability and is temperature tolerant for forming the TFC 190 on a surface. Although the first layer 104-1 is referred to herein as "a glass substrate," any suitable material having the desired mechanical and temperature-resistant properties may be used, such as ceramic, silicon, as well as glass, among others. For example, a glass substrate 104-1 may include any suitable type of glass known in the art, including but not limited to photoglass, borosilicate glass, such as Pyrex°, soda lime glass, quartz, or other glass material. In some embodiments, the glass substrate may include a photoimageable glass, such as APEX° Glass, manufactured by Life Bioscience, Inc., or other borosilicate-based glasses with oxide additions. In some embodiments, an overall thickness (e.g., a z-height) of the glass substrate 104-1 may be between 50 microns and 1,000 microns. A second layer 104-2 may include an TFC 190 embedded in an insulating material 133-1 (e.g., an insulating material 133, as described below). In some embodiments, an overall thickness (e.g., a z-height) of the insulating material 133-1 in the second layer 104-2 may be between 25 microns and 150 microns. A third layer 104-3 may include a die 114-3 and/or a die 114-5 embedded in an insulating material 133-2. In some embodiments, an overall thickness (e.g., a z-height) of the insulating material 133-2 in the third layer 104-3 may be between 200 microns and 800 microns (e.g., equal to a thickness of die 114-3 or 114-5 and an underfill material 127). In some embodiments, the insulating materials 133-1 and 133-2 are a same insulating material. In some embodiments, the insulating material 133-1 is different than the insulating material 133-2.

The die 114-2 may be attached to a bottom surface of the cavity 107 by a die-attach film (DAF) 109. A DAF 109 may be any suitable material, including a non-conductive adhesive, die attach film, a B-stage underfill, or a polymer film with adhesive property. A DAF 109 may have any suitable dimensions, for example, in some embodiments, a DAF 109 may have a thickness (e.g., height or z-height) between 5 microns and 10 microns.

The multi-layer die subassembly 104 may include multiple interconnects. As used herein, the term a "multi-layer die subassembly" 104 may refer to a composite die having a glass substrate layer, two or more stacked dielectric layers with one or more dies in each layer on the glass substrate layer, and conductive interconnects and/or conductive pathways connecting the one or more dies, including dies in non-adjacent layers. As used herein, the terms a "multi-layer die subassembly" and a "composite die" may be used interchangeably. The glass substrate may reduce warpage and may provide a more robust surface for attachment of the multi-layer die subassembly 104 to a package substrate 102 or other substrate (e.g., an interposer or a circuit board). The die 114-2 in the first layer 104-1 may be coupled to the dies 114-3, 114-5 in the third layer 104-3 through the conductive pillars 152, other conductive pathways (not shown), and die-to-die (DTD) interconnects 130. The dies 114-3, 114-5 in the third layer 104-3 may be electrically coupled to the package substrate through the conductive pillars 152, other conductive pathways (not shown), the TGVs 192, and die-to-package substrate (DTPS) interconnects 150, which may be power delivery interconnects or high-speed signal interconnects. In particular, the top surface of the package substrate 102 may include a set of conductive contacts 146. The multi-layer die subassembly 104 may include a set of conductive contacts 144 on the bottom surface 170-1. The die 114-2 may include a set of conductive contacts 124 on the top surface of the die. The dies 114-3, 114-5 may include a set of conductive contacts 122 on the bottom surface of the die. As shown for the die 114-2, the conductive contacts 124 on the top surface of the die 114-2 may be electrically and mechanically coupled through the conductive pillars 152 to the conductive contacts 122 on the bottom surface of the dies 114-3, 114-5 by DTD interconnects 130. As shown for the dies 114-3, 114-5, the conductive contacts 122 on the bottom surface of the dies may be electrically and mechanically coupled through the conductive pillars 152, the TGVs 192, and the conductive contacts 144 to the conductive contacts 146 on the top surface of the package substrate by DTPS interconnects 150.

An "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

The conductive pillars 152 may be formed of any appropriate conductive material, such as copper, silver, nickel, gold, aluminum, or other metals or alloys, for example. The conductive pillars 152 may be formed using any suitable process, including, for example, an SAP. In some embodiments, the conductive pillars 152 disclosed herein may have a pitch between 50 microns and 500 microns. As used herein, pitch is measured center-to-center (e.g., from a center of a conductive pillar to a center of an adjacent conductive pillar). The conductive pillars 152 may have any suitable size and shape. In some embodiments, the conductive pillars may have a circular, rectangular, or other shaped cross-section. In some embodiments, the conductive pillars 152 have a thickness (e.g., z-height) between 25 microns and 150 microns.

The TGVs 192 may be formed of any appropriate conductive material, such as copper, silver, nickel, gold, aluminum, or other metals or alloys, for example. The TGVs 192 may be formed using any suitable process, including, for example, a direct laser drilling or laser induced deep etching process, as described below with reference to FIG. 3. In some embodiments, the TGVs 192 disclosed herein may have a pitch between 50 microns and 500 microns. As used herein, pitch is measured center-to-center (e.g., from a center of a TGV to a center of an adjacent TGV). The TGVs 192 may have any suitable size and shape. In some embodiments, the TGVs 192 may have a circular, rectangular, or other shaped cross-section. In some embodiments, the TGVs 192 may have a thickness (e.g., z-height) between 50 microns and 1,000 microns.

In some embodiments, the package substrate 102 may be formed using a lithographically defined via packaging process. In some embodiments, the package substrate 102 may be manufactured using standard organic package manufacturing processes, and thus the package substrate 102 may take the form of an organic package. In some embodiments, the package substrate 102 may be a set of redistribution layers formed on a panel carrier by laminating or spinning on a dielectric material, and creating conductive vias and lines by laser drilling or ablation and plating. In some embodiments, the package substrate 102 may be formed on a removable carrier using any suitable technique, such as a redistribution layer technique. Any method known in the art for fabrication of the package substrate 102 may be used, and for the sake of brevity, such methods will not be discussed in further detail herein.

In some embodiments, the package substrate 102 may be a lower density medium and the die 114 (e.g., the die 114-3, 114-5) may be a higher density medium or have an area with a higher density medium. As used herein, the term "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive build-up process with advanced lithography (with small vertical interconnect features formed by advanced laser or lithography processes), while a lower density medium may be a printed circuit board (PCB) manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual damascene process.

Although FIG. 1A shows the dies 114-2, 114-3, 114-5 as single-sided dies, the dies 114 may be a single-sided or a double-sided die and may be a single-pitch die or a mixed-pitch die. In this context, a double-sided die refers to a die that has connections on both surfaces. A die 114 that has interconnects 130 of different pitches at a same surface may be referred to as a mixed-pitch die. For example, as shown for the die 114-2, the top surface may have DTD interconnects 130 that may have a same pitch on the same surface (e.g., a single pitch die). In another example, as shown for the dies 114-3, 114-5, the bottom surface may have DTD interconnects 130 that may have a different pitch on the same surface (e.g., a mixed-pitch die). In some embodiments, the DTD interconnects may have a pitch between 5 microns and 200 microns (e.g., between 5 microns and 100 microns). In some embodiments, the DTPS interconnects may have a pitch between 50 microns and 800 microns (e.g., between 100 microns and 500 microns). In some embodiments, a double-sided die may include through silicon vias (TSVs) to form connections on both surfaces. The active surface of a double-sided die, which is the surface containing one or more active devices and a majority of interconnects, may face either direction depending on the design and electrical requirements. In some embodiments, the die 114-2 is an interposer or bridge die (e.g., an embedded multi-die bridge (EMIB) die). In some embodiments, additional dies may be disposed on the top surface of the die 114-2. In some embodiments, additional components may be disposed on the top surface of the dies 114-3, 114-5. Additional passive components, such as surface-mount resistors, capacitors, and/or inductors, may be disposed on the top surface or the bottom surface of the package substrate 102, or embedded in the package substrate 102. Placing dies in separate layers such that the dies at least partially overlap may reduce routing congestion and may improve utilization of the dies by enabling a die in a non-adjacent layer to be connected to a package substrate by any of the interconnects disclosed herein.

Although FIG. 1A shows the dies 114 in a particular arrangement, the dies 114 may be in any suitable arrangement. For example, a die 114-3 may extend over a die 114-2 by an overlap distance 191, and a die 114-5 may extend over a die 114-2 by an overlap distance 193. The overlap distances 191, 193 may be any suitable distance. In some embodiments, the overlap distance 191, 193 may be between 0.5 millimeters and 50 millimeters (e.g., between 0.75 millimeters and 20 millimeters, or approximately 10 millimeters). In some embodiments, the overlap distance 191, 193 may be between 0.25 millimeters and 25 millimeters. In some embodiments, the overlap distance 191, 193 may be between 0.25 millimeters and 5 millimeters.

In the embodiment of FIG. 1A, the die 114-2 may provide high density interconnect routing in a localized area of the microelectronic assembly 100. In some embodiments, the presence of the die 114-2 may support direct chip attach of fine-pitch semiconductor dies (not shown) that cannot be attached entirely directly to the package substrate 102. In particular, as discussed above, the die 114-2 may support trace widths and spacings that are not achievable in the package substrate 102. The proliferation of wearable and mobile electronics, as well as Internet of Things (IoT) applications, are driving reductions in the size of electronic systems, but limitations of the PCB manufacturing process and the mechanical consequences of thermal expansion during use have meant that chips having fine interconnect pitch cannot be directly mounted to a PCB. Various embodiments of the microelectronic assemblies 100 disclosed herein may be capable of supporting chips with high density interconnects and chips with low-density interconnects without sacrificing performance or manufacturability.

The microelectronic assembly 100 of FIG. 1A may also include a circuit board (not shown). The package substrate 102 may be coupled to the circuit board by second-level interconnects at the bottom surface of the package substrate 102. The second-level interconnects may be any suitable second-level interconnects, including solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the second-level interconnects may not couple the package substrate 102 to a circuit board, but may instead couple the package substrate 102 to another IC package, an interposer, or any other suitable component. In some embodiments, the multi-layer die subassembly may not be coupled to a package substrate 102, but may instead be coupled to a circuit board, such as a PCB.

The microelectronic assembly 100 of FIG. 1A may also include an underfill material 127. In some embodiments, the underfill material 127 may extend between the glass substrate layer 104-1 and the package substrate 102 around the associated DTPS interconnects 150. In some embodiments, the underfill material 127 may extend between different ones of the dies 114 around the associated DTD interconnects 130. The underfill material 127 may be an insulating material, such as an appropriate epoxy material. In some embodiments, the underfill material 127 may include a capillary underfill, non-conductive film (NCF), or molded underfill. The underfill material 127 may be selected to have a coefficient of thermal expansion (CTE) that may mitigate or minimize the stress between different ones of the dies 114. In some embodiments, the underfill material 127 may include an epoxy flux that assists with soldering the glass substrate 104-1 to the package substrate 102 when forming the DTPS interconnects 150, and then polymerizes and encapsulates the DTPS interconnects 150. The underfill material 127 may be selected to have a coefficient of thermal expansion (CTE) that may mitigate or minimize the stress between the glass substrate 104-1 and the package substrate 102 arising from uneven thermal expansion in the microelectronic assembly 100. In some embodiments, the CTE of the underfill material 127 may have a value that is intermediate to the CTE of the package substrate 102 (e.g., the CTE of the dielectric material of the package substrate 102) and a CTE of the glass substrate 104-1.

The DTPS interconnects 150 disclosed herein may take any suitable form. In some embodiments, a set of DTPS interconnects 150 may include solder (e.g., solder bumps or balls that are subject to a thermal reflow to form the DTPS interconnects 150). In some embodiments, a set of DTPS interconnects 150 may include an anisotropic conductive material, such as an anisotropic conductive film or an anisotropic conductive paste. An anisotropic conductive material may include conductive materials dispersed in a non-conductive material.

The DTD interconnects 130 disclosed herein may take any suitable form. The DTD interconnects 130 may have a finer pitch than the DTPS interconnects 150 in a microelectronic assembly. In some embodiments, the dies 114 on either side of a set of DTD interconnects 130 may be unpackaged dies, and/or the DTD interconnects 130 may include small conductive bumps (e.g., copper bumps) attached to the conductive contacts 122, 123 on either side of the DTD interconnect 130 by solder. The DTD interconnects 130 may have too fine a pitch to couple to the package substrate 102 directly (e.g., too fine to serve as DTPS interconnects 150). In some embodiments, a set of DTD interconnects 130 may include solder. In some embodiments, a set of DTD interconnects 130 may include an anisotropic conductive material, such as any of the materials discussed above. In some embodiments, the DTD interconnects 130 may be used as data transfer lanes, while the DTPS interconnects 150 may be used for power and ground lines, among others. In some embodiments, some or all of the DTD interconnects 130 in a microelectronic assembly 100 may be metal-to-metal interconnects (e.g., copper-to-copper interconnects, or plated interconnects). In such embodiments, the conductive contacts 122, 123 on either side of the DTD interconnect 130 may be bonded together (e.g., under elevated pressure and/or temperature) without the use of intervening solder or an anisotropic conductive material. Any of the conductive contacts disclosed herein (e.g., the conductive contacts 122, 123, 144, and/or 146) may include bond pads, solder bumps, conductive posts, or any other suitable conductive contact, for example. In some embodiments, some or all of the DTD interconnects 130 in a microelectronic assembly 100 may be solder interconnects that include a solder with a higher melting point than a solder included in some or all of the DTPS interconnects 150. For example, when the DTD interconnects 130 in a microelectronic assembly 100 are formed before the DTPS interconnects 150 are formed, solder-based DTD interconnects 130 may use a higher-temperature solder (e.g., with a melting point above 200 degrees Celsius), while the DTPS interconnects 150 may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth) or tin, silver, and bismuth. In some embodiments, a lower-temperature solder may include indium, indium and tin, or gallium.

In the microelectronic assemblies 100 disclosed herein, some or all of the DTPS interconnects 150 may have a larger pitch than some or all of the DTD interconnects 130. DTD interconnects 130 may have a smaller pitch than DTPS interconnects 150 due to the greater similarity of materials in the different dies 114 on either side of a set of DTD interconnects 130 than between the die 114 and the package substrate 102 on either side of a set of DTPS interconnects 150. In particular, the differences in the material composition of a die 114 and a package substrate 102 may result in differential expansion and contraction of the die 114 and the package substrate 102 due to heat generated during operation (as well as the heat applied during various manufacturing operations). To mitigate damage caused by this differential expansion and contraction (e.g., cracking, solder bridging, etc.), the DTPS interconnects 150 may be formed larger and farther apart than DTD interconnects 130, which may experience less thermal stress due to the greater material similarity of the pair of dies 114 on either side of the DTD interconnects. In some embodiments, the DTPS interconnects 150 disclosed herein may have a pitch between 80 microns and 500 microns, while the DTD interconnects 130 disclosed herein may have a pitch between 7 microns and 100 microns.

The multi-layer die subassembly 104 may include an insulating material 133 (e.g., the insulating material 133-1 of the second layer 104-2 and the insulating material 133-2 of the third layer 104-3) to form the multiple layers (e.g., a dielectric material formed in multiple layers, as known in the art) and to embed one or more dies in a layer. In some embodiments, the insulating material 133 of the multi-layer die subassembly 104 may be a dielectric material, such as an organic dielectric material, a fire retardant grade 4 material (FR-4), bismaleimide triazine (BT) resin, polyimide materials, glass reinforced epoxy matrix materials, or low-k and ultra low-k dielectric (e.g., carbon-doped dielectrics, fluorine-doped dielectrics, porous dielectrics, and organic polymeric dielectrics). In some embodiments, the insulating material 133 of the multi-layer die subassembly 104 may be a mold material, such as an organic polymer with inorganic silica particles. The multi-layer die subassembly 104 may include one or more conductive pillars 152 through the dielectric material 133-1. The multi-layer die subassembly 104 may have any suitable dimensions. For example, in some embodiments, a thickness of the multi-layer die subassembly 104 may be between 100 microns and 2,000 microns. In some embodiments, the multi-layer die subassembly 104 may be a composite die, such as stacked dies. The multi-layer die subassembly 104 may have any suitable number of layers, any suitable number of dies, and any suitable die arrangement. For example, in some embodiments, the multi-layer die subassembly 104 may have between 3 and 20 layers of dies. In some embodiments, the multi-layer die subassembly 104 may include a layer having between 2 and 10 dies.

The package substrate 102 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 102 may be a dielectric material, such as an organic dielectric material, a fire retardant grade 4 material (FR-4), BT resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 102 is formed using standard PCB processes, the package substrate 102 may include FR-4, and the conductive pathways in the package substrate 102 may be formed by patterned sheets of copper separated by build-up layers of the FR-4. The conductive pathways in the package substrate 102 may be bordered by liner materials, such as adhesion liners and/or barrier liners, as suitable.

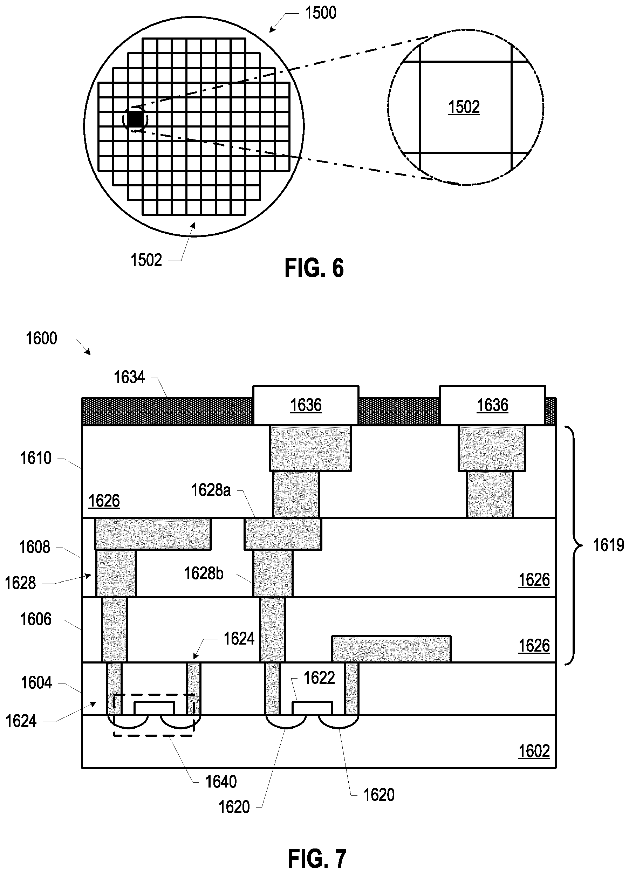

The dies 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). Example structures that may be included in the dies 114 disclosed herein are discussed below with reference to FIG. 7. The conductive pathways in the dies 114 may be bordered by liner materials, such as adhesion liners and/or barrier liners, as suitable.

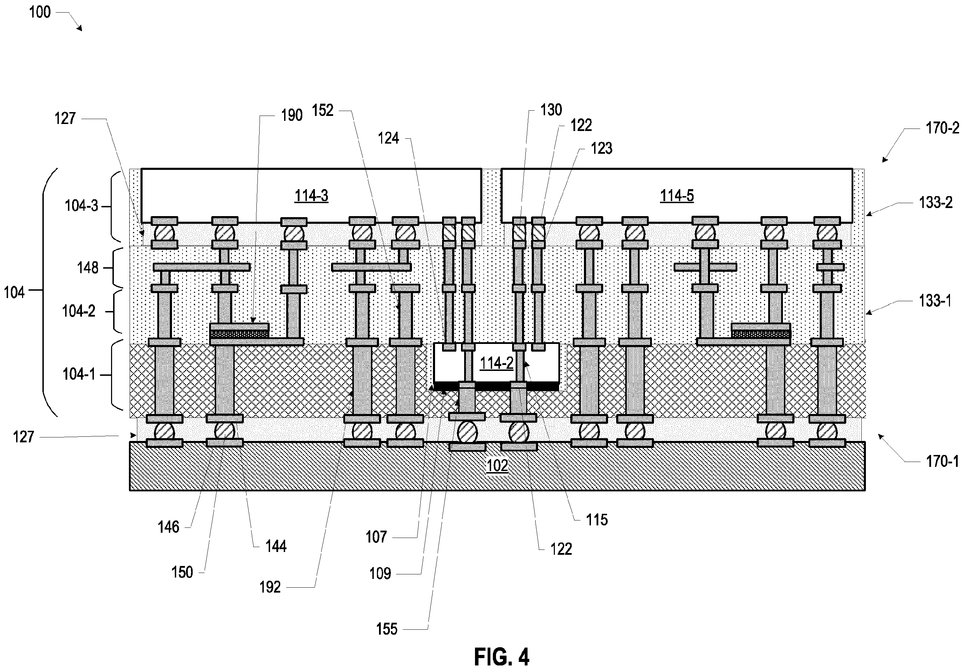

In some embodiments, the die 114 may include conductive pathways to route power, ground, and/or signals to/from other dies 114 included in the microelectronic assembly 100. For example, the die 114-2 may include TSVs, including a conductive material via, such as a metal via, isolated from the surrounding silicon or other semiconductor material by a barrier oxide), or other conductive pathways through which power, ground, and/or signals may be transmitted between the package substrate 102 and one or more dies 114 "on top" of the die 114-2 (e.g., in the embodiment of FIG. 1A, the dies 114-3 and/or 114-5). In some embodiments, the die 114-2 may not route power and/or ground to the dies 114-3 and 114-5; instead, the dies 114-3, 114-5 may couple directly to power and/or ground lines in the package substrate 102 by the conductive pillars 152 and the conductive TGVs 192. By allowing the dies 114-3 and 114-5 to couple directly to power and/or ground lines in the package substrate 102 via the conductive pillars 152, such power and/or ground lines need not be routed through the die 114-2, allowing the die 114-2 to be made smaller or to include more active circuitry or signal pathways. In some embodiments, the die 114-2 may only include conductive pathways, and may not contain active or passive circuitry. In other embodiments, the die 114-2 may include active or passive circuitry (e.g., transistors, diodes, resistors, inductors, and capacitors, among others). In some embodiments, the die 114-2 may include one or more device layers including transistors (e.g., as discussed below with reference to FIG. 7). When the die 114-2 includes active circuitry, power and/or ground signals may be routed through the package substrate 102 and to the die 114-2 through the conductive contacts 122 on the bottom surface of the die 114-2, as shown below in FIG. 4. In some embodiments, the die 114-2 in the first layer 104-1, also referred to herein as "base die," "interposer die," or "bridge die," may be thicker than the dies 114-3, 114-5 in the third layer 104-3. The die 114-2 of the microelectronic assembly 100 may be a single-sided die (in the sense that the die 114-2 only has conductive contacts on a single surface), as shown, or may be a double-sided die (in the sense that the die 114-2 has conductive contacts 122, 124 on two surfaces (e.g., a top surface and a bottom surface, as shown in FIG. 4)), and may be a mixed-pitch die (in the sense that the die 114-2 has sets of conductive contacts 122, 124 with different pitches).

The elements of the microelectronic assembly 100 may have any suitable dimensions. Only a subset of the accompanying figures are labeled with reference numerals representing dimensions, but this is simply for clarity of illustration, and any of the microelectronic assemblies 100 disclosed herein may have components having the dimensions discussed herein. In some embodiments, a thickness 164 of the package substrate 102 (e.g., height or z-height) may be between 0.1 millimeters and 3 millimeters (e.g., between 0.3 millimeters and 2 millimeters, between 0.25 millimeters and 0.8 millimeters, or approximately 1 millimeter).

Many of the elements of the microelectronic assembly 100 of FIG. 1A are included in other ones of the accompanying figures; the discussion of these elements is not repeated when discussing these figures, and any of these elements may take any of the forms disclosed herein. In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

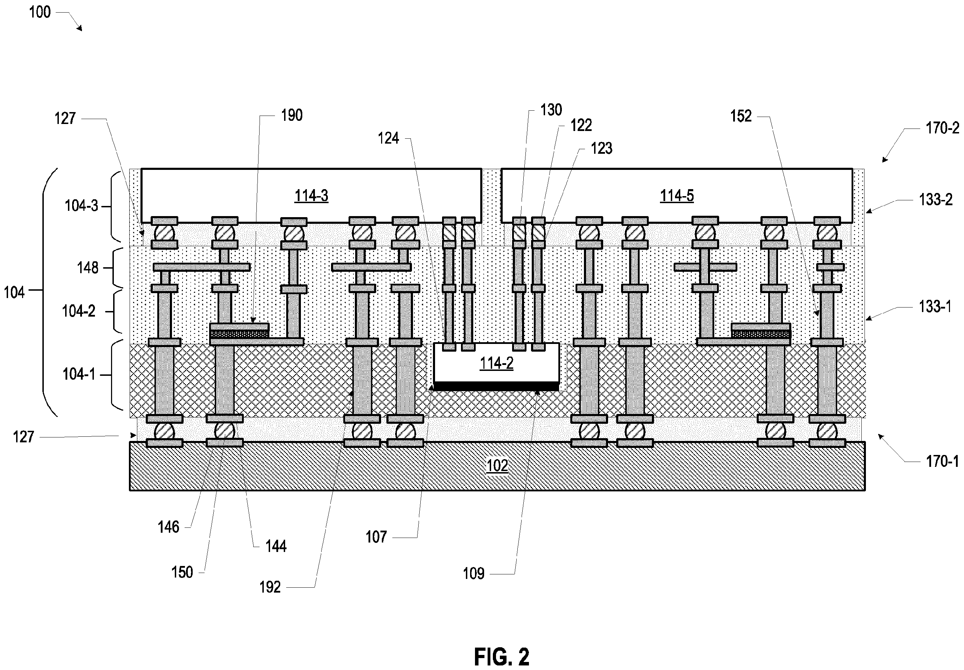

FIG. 2 is a side, cross-sectional view of a microelectronic assembly 100, in accordance with various embodiments. In the microelectronic assemblies 100 disclosed herein, the multi-layer die subassembly 104 may include one or more redistribution layers (RDL) 148 having conductive pathways (e.g., conductive lines and vias) through a dielectric material. For example, FIG. 2 illustrates an embodiment of a microelectronic assembly 100 in which the multi-layer die subassembly 104 may include a glass substrate 104-1 having a TGV 192 and a die 114-2 nested in a cavity 107, a second layer 104-2, on the first layer 104-1, having an integrated TFC 190 and a conductive pillar 152, a redistribution layer (RDL) 148 on the second layer 104-2, and a third layer 104-3, on the RDL 148, having a die 114-3 and a die 114-5. In some embodiments, a multi-layer die subassembly 104 may further include an RDL 148 at a first surface 170-1.

FIGS. 3A-3N are side, cross-sectional views of various stages in an example process for manufacturing an example microelectronic assembly, in accordance with various embodiments. Any suitable techniques may be used to manufacture the microelectronic assemblies disclosed herein. For example, FIGS. 3A-3N are side, cross-sectional views of various stages in an example process for manufacturing a microelectronic assembly 100 of FIG. 2, in accordance with various embodiments. Although the operations discussed below with reference to FIGS. 3A-3N are illustrated in a particular order, these operations may be performed in any suitable order. Additionally, although particular assemblies are illustrated in FIGS. 3A-3N, the operations discussed below with reference to FIGS. 3A-3N may be used to form any suitable assemblies. In the embodiment of FIGS. 3A-3N, the TFC 190 is first integrated into a multi-layer die subassembly 104, and then the multi-layer die subassembly 104 may be coupled to the package substrate 102. This approach may allow for tighter tolerances, and may be particularly desirable for integrating a plurality of TFC 190, for relatively small dies 114, and for a multi-layer die subassembly 104 having three or more layers.

FIG. 3A illustrates an assembly subsequent to forming a plurality of via openings 392 (e.g., through-holes for TGV 192 formation) through a glass substrate 104-1. A glass substrate 104-1 may include any suitable type of glass, as described above with reference to FIG. 1A. The plurality of via openings 392 may be formed to have any suitable dimensions based on the desired size and shape of the TGVs (e.g., the TGVs 192 of FIG. 1), including, for example, straight walls, slanted walls, a circular cross-section, or a rectangular cross-section. In some embodiments, the via openings 392 may have a cross-section dimension between 50 microns and 350 microns. In some embodiments, the via openings 392 may have a cross-section dimension between 50 microns and 125 microns. The plurality of via openings 392 may be formed using any suitable process, such as crack-free laser drilling. Laser drilling techniques generally form openings having a conical profile where the opening is larger towards the drilling side. Other examples of suitable processes include a laser ablation process, a mediablasting or sandblasting process, an ultrasonic drilling process, or an etching process (such as a chemical wet etching process or a dry reactive ion etching process), or a combination of these processes. In some embodiments, the openings 392 may be formed by exposing a photoimageable glass to ultraviolet (UV) light. For example, a mask material may be used to define the area of the photoimageable glass that is exposed to ultraviolet light. The masked photoimageable glass may be exposed to ultraviolet light and heated to an elevated temperature causing a change of the structural and/or chemical properties of the area exposed to ultraviolet light, such that the exposed area may have a higher etch rate than the unexposed area of the photoimageable glass. The openings 392 may be etched in the exposed area of the photoimageable glass using an acid, such as hydrofluoric acid (HF), ethylenediamine pyrocatechol, potassium hydroxide/isopropyl alcohol, or tetramethylammonium hydroxide.

FIG. 3B illustrates an assembly subsequent to providing a conductive material in the via openings 392 of FIG. 3A to form TGVs 192. The conductive material may be deposited using any suitable technique, such as electroplating, sputtering, or electroless plating. In some embodiments, the conductive material is polished or planarized subsequent to deposition to make the conductive material flush with the surfaces of the glass substrate 104-1. The conductive material may be any suitable conductive material as described above with reference to FIG. 1A. The technique used to deposit the conductive material may depend on the type of conductive material used. In some embodiments, the conductive material may be initially deposited to overfill the via openings 392, where the conductive material extends above the top surface 370-2 and/or below the bottom surface 370-1 of the glass substrate 104-1, and the extra conductive material may be removed by polishing or grinding so that the conductive material is substantially co-planar with the top and bottom surfaces 370-2, 370-1 of the glass substrate 104-1. In some embodiments, a seed layer (not shown) may be deposited on an inner surface of the via openings 392 prior to depositing the conductive material. The seed layer may be deposited using any suitable technique, including, for example, sputtering, chemical vapor deposition (CVD), atomic layer deposition (ALD), or electroless plating. The seed layer may be any suitable conductive material, including copper. In some embodiments, the seed layer may be omitted.

FIG. 3C illustrates an assembly subsequent to forming a first capacitor plate 196 (e.g., a first conductive layer, plate or trace that forms a bottom electrode of the TFC 190) on the top surface 370-2 of the glass substrate 104-1. The first capacitor plate 196 may be any suitable conductive material, including copper. The first capacitor plate 196 may be formed using any suitable technique, including an SAP or forming an RDL (not shown) on the top surface 370-2 of the glass substrate 104-1. The RDL may be manufactured using any suitable technique, such as a PCB technique or an SAP technique. The first capacitor plate 196 may be electrically coupled to a TGV 192.

FIG. 3D illustrates an assembly subsequent to providing a dielectric film 135 on the first capacitor plate 196. The dielectric film 135 may be formed using any suitable process, including lamination, or slit coating and curing, or sputtering, or chemical vapor deposition (CVD), or atomic layer deposition (ALD). In some embodiments, the dielectric material 135 may be removed (e.g., patterned and/or thinned) using any suitable technique, including grinding, or etching, such as a wet etch, a dry etch (e.g., a plasma etch), a wet blast, or a laser ablation (e.g., using excimer laser). In some embodiments, the top surface of the dielectric material 135 may be polished. In some embodiments, the dielectric material 135 may be subsequently cured or annealed.

FIG. 3E illustrates an assembly subsequent to forming a second capacitor plate 198 (e.g., a first conductive layer, pad, or trace that forms a top electrode of the TFC 190) on the dielectric material 135. The second capacitor plate 198 may be formed of any suitable conductive material, including copper. The second capacitor plate 198 may be formed using any suitable technique, including an SAP technique or forming an RDL (not shown) on the top and/or bottom surfaces of the assembly. The RDL may be manufactured using any suitable technique, such as a PCB technique or an SAP technique. In some embodiments, the dielectric material 135 and the second capacitor plate 198 may be patterned together after deposition using, for example, a hard mask.

FIG. 3F illustrates an assembly subsequent to forming conductive contacts 344 on the top and bottom surfaces 370-2, 370-1 of the glass substrate 104-1. In some embodiments, additional conductive traces (not shown) may be formed. The conductive contacts 344 may be formed of any suitable conductive material, including copper. The conductive contacts 344 may be formed using any suitable technique, including an SAP technique or forming an RDL (not shown) on the top and/or bottom surfaces of the assembly. The RDL may be manufactured using any suitable technique, such as a PCB technique or an SAP technique.

FIG. 3G illustrates an assembly subsequent to forming a cavity 107 in a top surface 370-2 of the glass substrate 104-1. The cavity 107 may be formed to have any suitable dimensions based on the size and shape of the nested die 114-2, as shown in FIG. 3H. For example, the cavity 107 may be formed to have straight walls or slanted walls, and a rectangular cross-section. The cavity 107 may be formed using any suitable process, such as described above with reference to FIG. 3A relating to forming via openings 392.

FIG. 3H illustrates an assembly subsequent to placing a die 114-2 in the cavity 107. The die 114-2 may be placed using any suitable technique, including a pick and place tooling. The die 114-2 may be attached to the bottom surface of the cavity 107 (e.g., the surface towards the bottom surface 370-1 of the glass substrate 104-1) using any suitable technique, including a DAF 109. In some embodiments, the DAF 109 may be attached to the bottom surface of the die 114-2 prior to placing in the cavity 107.

FIG. 3I illustrates an assembly subsequent to providing an insulating material 133-1 on a top surface 370-2 of the glass substrate 104-1 and on and around the die 114-2 and the TFC 190. The insulating material 133-1 may be formed using any suitable process, including lamination, or slit coating and curing.

FIG. 3J illustrates an assembly subsequent to forming pillar openings 153 in the insulating material 133-1. The pillar openings 153 may be formed using any suitable technique, including a lithographic process or laser drilling (e.g., carbon dioxide or ultraviolet). The pillar openings 153 may be formed to expose the conductive contacts 344 at the top surface 370-2 of the glass substrate 104-1 and the conductive contacts 124 at the top surface of the die 114-2. In some embodiments, the pillar openings 153 may be cleaned using any suitable process, for example, a wet desmear process, or a dry plasma clean process. Although the pillar openings 153 are shown as having substantially vertical sidewalls, in some embodiments, the pillar openings 153 may have angled sidewalls to form conical-shaped pillars.

FIG. 3K illustrates an assembly subsequent to depositing a conductive material, such as copper, in the pillar openings 153 of FIG. 3J to generate conductive pillars 152 and form the connection to the TFC 190. The conductive pillars 152 may be formed such that the TFC 190 may include a first conductive pillar 152-1 electrically coupled to the first capacitor plate 196 and a second conductive pillar 152-2 electrically coupled to the second capacitor plate 198. The conductive pillars 152 may be formed using any suitable technique, for example, an SAP technique. The conductive pillars 152 may have any suitable dimensions, as described above with reference to FIG. 1A. In some embodiments, the conductive pillars 152 may span one or more layers. In some embodiments, the conductive material may be initially deposited to overfill the pillar openings 153, where the conductive material extends above the top surface of the insulating material 133-1, and the extra conductive material may be removed by polishing or grinding so that the conductive material is substantially co-planar with the top surface of the insulating material 133-1. In some embodiments, a seed layer (not shown) may be deposited on an inner surface of the pillar openings 153 prior to depositing the conductive material. The seed layer may be deposited using any suitable technique, including, for example, sputtering or electroless plating. The seed layer may be any suitable conductive material, including copper. In some embodiments, the seed layer may be omitted. FIG. 3K depicts the formation of the second layer 104-2 of the multi-layer die subassembly 104.

FIG. 3L illustrates an assembly subsequent to forming conductive contacts 344 on the top surface of the conductive pillars 152. The conductive contacts 344 may be any suitable conductive material, including copper. The conductive contacts 344 may be formed using any suitable technique, including an SAP technique or forming an RDL (e.g., as shown in FIG. 3M) on the top surface of the assembly.

FIG. 3M illustrates an assembly subsequent to forming an RDL 148 on a top surface of the assembly of FIG. 3L. The RDL 148 may be manufactured using any suitable technique, such as a PCB technique or an SAP technique. In some embodiments, the RDL 148 may be omitted.

FIG. 3N illustrates an assembly subsequent to placing and coupling dies 114-3, 114-5, forming DTD interconnects 130, providing an insulating material 133 around the dies 114-3, 114-5, depositing a solder resist layer (not shown), and attaching solder balls 134 to conductive contacts 344 (e.g., conductive contacts 144 in FIG. 1A) on a bottom surface 170-1 for coupling to a package substrate or to a circuit board. The dies 114-3, 114-5 may be placed using any suitable technique, such as by pick and place tooling. The dies 114-3, 114-5 may include a set of first conductive contacts 122 on a bottom surface. In some embodiments, the DTD interconnects 130 may include solder. In such embodiments, the assembly may be subjected to a solder reflow process, such as thermal compression bonding (TCB), during which solder components of the DTD interconnects 130 melt and bond to mechanically and electrically couple the dies 114-3, 114-5. In some embodiments, the insulating material 133 may be initially deposited on and over the dies 114-3, 114-5 and then polished back to the top surfaces (e.g., the second surface 170-2) of the dies 114-3, 114-5. In some embodiments, underfill 127 may be dispensed around the DTD interconnects 130 prior to depositing the insulating material 133. In some embodiments, underfill 127 around the DTD interconnects 130 may be omitted. The assembly of FIG. 3N may itself be a microelectronic assembly 100, as shown. Further manufacturing operations may be performed on the microelectronic assembly 100 of FIG. 3N to form other microelectronic assembly 100; for example, the solder 134 may be used to couple the microelectronic assembly 100 of FIG. 3N to a package substrate 102 via DTPS interconnects 150, similar to the microelectronic assembly 100 of FIG. 2. If multiple assemblies are manufactured together, the assemblies may be singulated before coupling to a package substrate 102. Further operations may be performed as suitable either before or after singulating (e.g., depositing a mold material, attaching a heat spreader, etc.). In some embodiments, the dies 114-3 and/or 114-5 may include conductive contacts on a top surface and the assembly may be inverted or "flipped" and coupled to a package substrate or circuit board via interconnects on the top surface of the dies 114-3 and/or 114-5.

FIG. 4 is a side, cross-sectional view of a microelectronic assembly 100, in accordance with various embodiments. The microelectronic assembly 100 may include a package substrate 102 coupled to a multi-layer die subassembly 104. As shown in FIG. 4, the multi-layer die subassembly 104 may include a double-sided die 114-2 having a set of conductive contacts 122 on the bottom surface of the die, and a set of conductive contacts 124 on the top surface of the die, where the set of conductive contacts 122 on the bottom surface are electrically coupled to DTPS interconnects 150 by small TGVs 155. The double-sided die 114-2 may include, for example, an embedded multi-die interconnect bridge with TSVs (EMIB-T), an active die, or other microelectronic component. In particular, the multi-layer die subassembly 104 may include a glass substrate 104-1 (i.e., a first layer) having TGVs 192, a die 114-2 having TSVs 115, and small TGVs 155 coupled to conductive contacts 122 on a bottom surface of the die 114-2, a second layer 104-2 having an integrated thin film TFC 190, an RDL 148 on the second layer 104-2, and a third layer 104-3, on the RDL 148, having a die 114-3 and a die 114-5. The multi-layer die subassembly 104 may have a first surface 170-1 and an opposing second surface 170-2. The glass substrate 104-1 may include a cavity 107 with an opening facing the second surface 170-2 and the die 114-2 may be nested, fully or partially, in the cavity 107, and small TGVs 155 may extend from a bottom surface of the glass substrate 104-1 (e.g., at the first surface 170-1) to a bottom surface of the cavity 107 through the DAF 109 and couple with conductive contacts 122 on a bottom surface of the die 114-2. The die 114-2 in the first layer 104-1 may be coupled to the package substrate 102 through the small TGVs 155 and DTPS interconnects 150. In particular, the top surface of the package substrate 102 may include a set of conductive contacts 146. The multi-layer die subassembly 104 may include a set of conductive contacts 144 on the bottom surface 170-1. As shown for the die 114-2, the conductive contacts 122 on the bottom surface of the die 114-2 may be electrically and mechanically coupled through the small TGVs 155 to the conductive contacts 146 on the top surface of the package substrate 102 by DTPS interconnects 150.

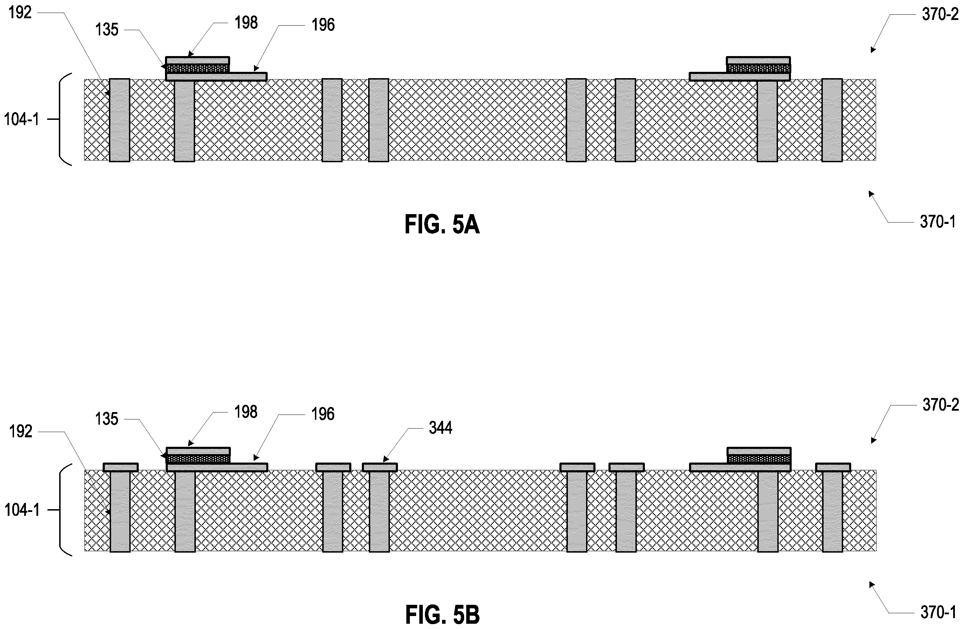

FIGS. 5A-5G are side, cross-sectional views of various stages in an example process for manufacturing an example microelectronic assembly, in accordance with various embodiments. Any suitable techniques may be used to manufacture the microelectronic assemblies disclosed herein. For example, FIGS. 5A-5G are side, cross-sectional views of various stages in an example process for manufacturing a microelectronic assembly 100 of FIG. 4, in accordance with various embodiments. Although the operations discussed below with reference to FIGS. 5A-5G are illustrated in a particular order, these operations may be performed in any suitable order. Additionally, although particular assemblies are illustrated in FIGS. 5A-5G, the operations discussed below with reference to FIGS. 5A-5G may be used to form any suitable assemblies. In the embodiment of FIGS. 5A-5G, the TFC 190 is first integrated into a multi-layer die subassembly 104, and then the multi-layer die subassembly 104 may be coupled to the package substrate 102. This approach may allow for tighter tolerances, and may be particularly desirable for integrating a plurality of TFC 190, for relatively small dies 114, and for a multi-layer die subassembly 104 having three or more layers.

FIG. 5A illustrates an assembly subsequent to forming a plurality of TGVs 192 through a glass substrate 104-1, forming a first capacitor plate 196 (e.g., a first conductive layer, pad, or trace that forms a bottom electrode of the TFC 190), a dielectric material 135, and a second capacitor plate 198 (e.g., a second conductive layer, pad, or trace that forms a top electrode of the TFC 190) on the dielectric material 135, as described above with reference to FIGS. 3A-3E.

FIG. 5B illustrates an assembly subsequent to forming conductive contacts 344 on a top surface 370-2 of the glass substrate 104-1, similar to as described above with reference to FIG. 3F. The conductive contacts 344 may be any suitable conductive material, including copper. The conductive contacts 344 may be formed using any suitable technique, including an SAP technique or forming an RDL (not shown) on the top and/or bottom surfaces of the assembly. The RDL may be manufactured using any suitable technique, such as a PCB technique or an SAP technique.

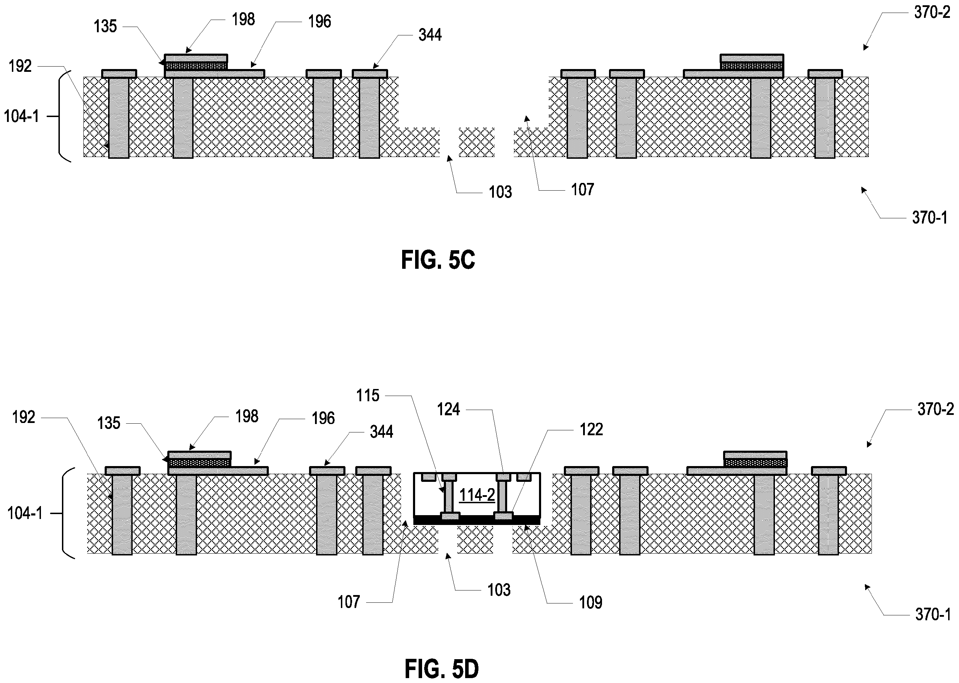

FIG. 5C illustrates an assembly subsequent to forming a cavity 107 in a top surface 370-2 of the glass substrate 104-1, as described above with reference to FIG. 3G, and small TGV openings 103 extending from a bottom surface 370-1 of the glass substrate 104-1 to the bottom surface of the cavity 107. The cavity 107 and small TGV openings 103 may be formed to have any suitable dimensions based on the size and shape of the nested die 114-2 and conductive contacts 122 on the bottom surface of the die 114-2, as shown in FIG. 5D. For example, the cavity 107 and/or small TGV openings 103 may be formed to have straight walls or slanted walls, and a rectangular cross-section. The cavity 107 and small TGV openings 103 may be formed using any suitable process, such as described above with reference to FIG. 3A.

FIG. 5D illustrates an assembly subsequent to placing a double-sided die 114-2 in the cavity 107, as described above with reference to FIG. 3H. The die 114-2 may include a set of conductive contacts 122 on a bottom surface, a set of conductive contacts 124 on a top surface, and TSVs 115 coupling the conductive contacts 122, 124 on the bottom and top surfaces of the die 114-2. The die 114-2 may be placed using any suitable technique, including a pick and place tooling. The die 114-2 may be attached to the bottom surface of the cavity 107 (e.g., the surface towards the bottom surface 370-1 of the glass substrate 104-1) using any suitable technique, including a DAF 109. In some embodiments, the DAF 109 may be attached to the bottom surface of the die 114-2 prior to placing in the cavity 107.

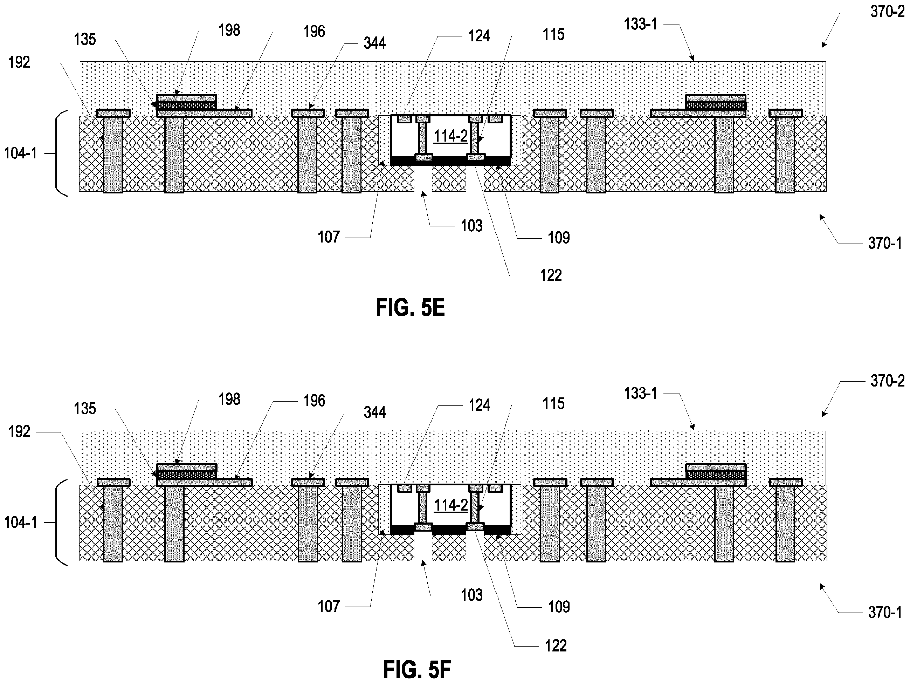

FIG. 5E illustrates an assembly subsequent to providing an insulating material 133-1 on a top surface 370-2 of the glass substrate 104-1 and on and around the die 114-2 and the TFC 190, as described above with reference to FIG. 3I. The insulating material 133-1 may be formed using any suitable process, including lamination, or slit coating and curing.

FIG. 5F illustrates an assembly subsequent to removing the DAF 109 from the small TGV openings 103 to expose the conductive contacts 122 on the bottom surface of the die 114-2. The DAF 109 may be removed using any suitable process, including plasma etching. In some embodiments, the small TSV openings 103 through the DAF 109 may be cleaned using any suitable process, for example, a wet desmear process or a dry plasma clean process.

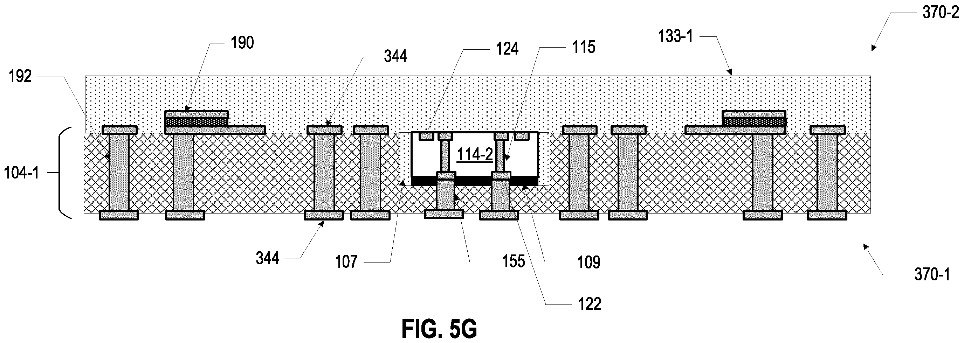

FIG. 5G illustrates an assembly subsequent to providing a conductive material in the small TGV openings 103 to form small TGVs 155, as described above with reference to FIG. 3B, and forming conductive contacts 344 on the bottom surface 370-1 of the glass substrate 104-1, as described above with reference to FIG. 3D. The small TGVs 155 and conductive contacts 344 may be any suitable conductive material, including copper, as described above with reference to FIG. 1A. The small TGVs 155 and conductive contacts 344 may be formed using any suitable technique, including an SAP technique, or forming an RDL (not shown) on the bottom surface of the assembly. The RDL may be manufactured using any suitable technique, such as a PCB technique or an SAP technique.

Further operations, as described above in FIGS. 3J-3N, may be performed to manufacture the microelectronic assembly of FIG. 4, including a microelectronic assembly of FIG. 4 that excludes the package substrate 102. Additional manufacturing operations may be performed to form the microelectronic assembly 100 of FIG. 4; for example, solder may be used to couple the microelectronic assembly 100 to a package substrate 102 via DTPS interconnects 150. If multiple composite assemblies are manufactured together, the composite assemblies may be singulated before coupling to a package substrate 102. Further operations may be performed as suitable either before or after singulating (e.g., depositing a mold material, attaching a heat spreader, etc.).

Although the microelectronic assemblies 100 disclosed herein show a particular number and arrangement of TFCs, dies, and interconnects, any number and arrangement of TFCs, dies, and interconnects may be used, and may further include one or more RDLs and package substrate portions. Further, although the microelectronic assemblies 100 disclosed herein show a particular arrangement of TFCs, the microelectronic assemblies 100 may have any number and arrangement of TFCs.

The microelectronic assemblies 100 disclosed herein may be used for any suitable application. For example, in some embodiments, a microelectronic assembly 100 may be used to provide an ultra-high density and high bandwidth interconnect for field programmable gate array (FPGA) transceivers and III-V amplifiers. More generally, the microelectronic assemblies 100 disclosed herein may allow "blocks" of different kinds of functional circuits to be distributed into different ones of the dies 114, instead of having all of the circuits included in a single large die, per some conventional approaches. In some such conventional approaches, a single large die would include all of these different circuits to achieve high bandwidth, low loss communication between the circuits, and some or all of these circuits may be selectively disabled to adjust the capabilities of the large die. However, because the conductive pillars 152, and/or the DTD interconnects 130 of the microelectronic assemblies 100 may allow high bandwidth, low loss communication between different ones of the dies 114 and different ones of the dies 114 and the package substrate 102, different circuits may be distributed into different dies 114, reducing the total cost of manufacture, improving yield, and increasing design flexibility by allowing different dies 114 (e.g., dies 114 formed using different fabrication technologies) to be readily swapped to achieve different functionality.

In another example, a die 114-2 that includes active circuitry in a microelectronic assembly 100 may be used to provide an "active" bridge between other dies 114 (e.g., between the dies 114-3 and 114-5). In another example, the die 114-2 in a microelectronic assembly 100 may be a processing device (e.g., a central processing unit, a graphics processing unit, a FPGA, a modem, an applications processor, etc.), and the dies 114-3 and/or 114-5 may include high bandwidth memory, transceiver circuitry, and/or input/output circuitry (e.g., Double Data Rate transfer circuitry, Peripheral Component interconnect Express circuitry, etc.). The particular high bandwidth memory die, input/output circuitry die, etc. may be selected for the application at hand.

In another example, the die 114-2 in a microelectronic assembly 100 may be a cache memory (e.g., a third level cache memory) or an active bridge die, and one or more dies 114-3 and/or 114-5 may be processing devices (e.g., a central processing unit, a graphics processing unit, a FPGA, a modem, an applications processor, etc.) that share the cache memory of the die 114-2.

In another example, a die 114 may be a single silicon substrate or may be a composite die, such as a memory stack.

The microelectronic assemblies 100 disclosed herein may be included in any suitable electronic component. FIGS. 6-9 illustrate various examples of apparatuses that may include, or be included in, any of the microelectronic assemblies 100 disclosed herein.

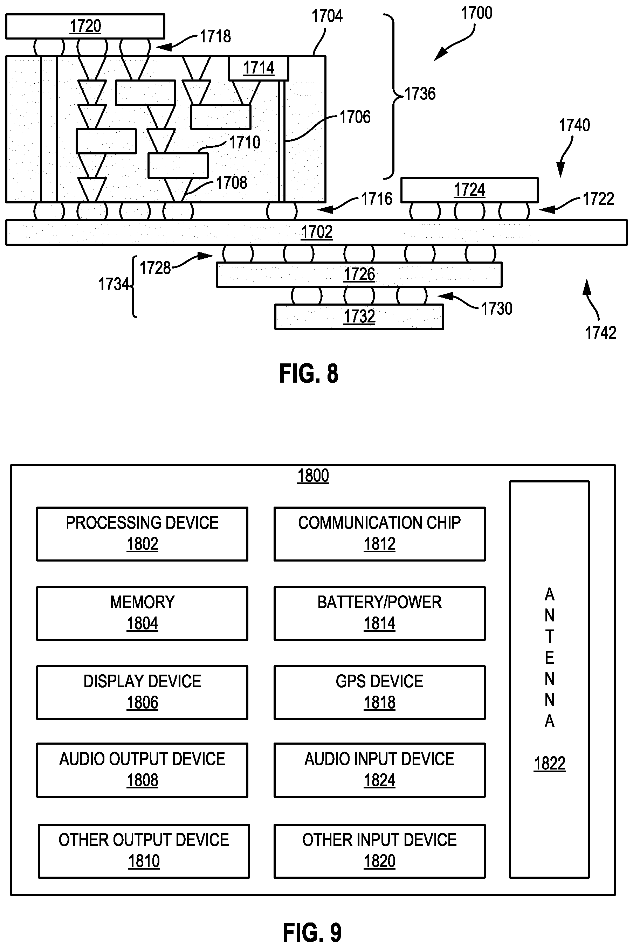

FIG. 6 is a top view of a wafer 1500 and dies 1502 that may be included in any of the microelectronic assemblies 100 disclosed herein (e.g., as any suitable ones of the dies 114). The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may be any of the dies 114 disclosed herein. The die 1502 may include one or more transistors (e.g., some of the transistors 1640 of FIG. 7, discussed below), supporting circuitry to route electrical signals to the transistors, passive components (e.g., signal traces, resistors, capacitors, or inductors), and/or any other IC components. In some embodiments, the wafer 1500 or the die 1502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 9) or other logic that is configured to store information in the memory devices or execute instructions stored in the memory array. In some embodiments, a die 1502 (e.g., a die 114) may be a central processing unit, a radio frequency chip, a power converter, or a network processor. Various ones of the microelectronic assemblies 100 disclosed herein may be manufactured using a die-to-wafer assembly technique in which some dies 114 are attached to a wafer 1500 that include others of the dies 114, and the wafer 1500 is subsequently singulated.

FIG. 7 is a cross-sectional side view of an IC device 1600 that may be included in any of the microelectronic assemblies 100 disclosed herein (e.g., in any of the dies 114). One or more of the IC devices 1600 may be included in one or more dies 1502 (FIG. 6). The IC device 1600 may be formed on a die substrate 1602 (e.g., the wafer 1500 of FIG. 6) and may be included in a die (e.g., the die 1502 of FIG. 6). The die substrate 1602 may be a semiconductor substrate composed of semiconductor material systems including, for example, n-type or p-type materials systems (or a combination of both). The die substrate 1602 may include, for example, a crystalline substrate formed using a bulk silicon or a silicon-on-insulator (SOI) substructure. In some embodiments, the die substrate 1602 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1602. Although a few examples of materials from which the die substrate 1602 may be formed are described here, any material that may serve as a foundation for an IC device 1600 may be used. The die substrate 1602 may be part of a singulated die (e.g., the dies 1502 of FIG. 6) or a wafer (e.g., the wafer 1500 of FIG. 6).

The IC device 1600 may include one or more device layers 1604 disposed on the die substrate 1602. The device layer 1604 may include features of one or more transistors 1640 (e.g., metal oxide semiconductor field-effect transistors (MOSFETs)) formed on the die substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 7 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the die substrate 1602 and two sidewall portions that are substantially perpendicular to the top surface of the die substrate 1602. In other embodiments, at least one of the metal layers that form the gate electrode may simply be a planar layer that is substantially parallel to the top surface of the die substrate 1602 and does not include sidewall portions substantially perpendicular to the top surface of the die substrate 1602. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the die substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the die substrate 1602 to form the S/D regions 1620. An annealing process that activates the dopants and causes them to diffuse farther into the die substrate 1602 may follow the ion-implantation process. In the latter process, the die substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., transistors 1640) of the device layer 1604 through one or more interconnect layers disposed on the device layer 1604 (illustrated in FIG. 7 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form a metallization stack (also referred to as an "ILD stack") 1619 of the IC device 1600.

The interconnect structures 1628 may be arranged within the interconnect layers 1606-1610 to route electrical signals according to a wide variety of designs; in particular, the arrangement is not limited to the particular configuration of interconnect structures 1628 depicted in FIG. 7. Although a particular number of interconnect layers 1606-1610 is depicted in FIG. 7, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the die substrate 1602 upon which the device layer 1604 is formed. For example, the lines 1628a may route electrical signals in a direction in and out of the page from the perspective of FIG. 7. The vias 1628b may be arranged to route electrical signals in a direction of a plane that is substantially perpendicular to the surface of the die substrate 1602 upon which the device layer 1604 is formed. In some embodiments, the vias 1628b may electrically couple lines 1628a of different interconnect layers 1606-1610 together.

The interconnect layers 1606-1610 may include a dielectric material 1626 disposed between the interconnect structures 1628, as shown in FIG. 7. In some embodiments, the dielectric material 1626 disposed between the interconnect structures 1628 in different ones of the interconnect layers 1606-1610 may have different compositions; in other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606-1610. In FIG. 7, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606-1610; for example, the conductive contacts 1636 may include other analogous features (e.g., posts) that route the electrical signals to external components. The conductive contacts 1636 may serve as the conductive contacts 122 or 124, as appropriate.

In some embodiments in which the IC device 1600 is a double-sided die (e.g., like the die 114-1), the IC device 1600 may include another metallization stack (not shown) on the opposite side of the device layer(s) 1604. This metallization stack may include multiple interconnect layers as discussed above with reference to the interconnect layers 1606-1610, to provide conductive pathways (e.g., including conductive lines and vias) between the device layer(s) 1604 and additional conductive contacts (not shown) on the opposite side of the IC device 1600 from the conductive contacts 1636. These additional conductive contacts may serve as the conductive contacts 122 or 124, as appropriate.

In other embodiments in which the IC device 1600 is a double-sided die (e.g., like the die 114-1), the IC device 1600 may include one or more TSVs through the die substrate 1602; these TSVs may make contact with the device layer(s) 1604, and may provide conductive pathways between the device layer(s) 1604 and additional conductive contacts (not shown) on the opposite side of the IC device 1600 from the conductive contacts 1636. These additional conductive contacts may serve as the conductive contacts 122 or 124, as appropriate.

FIG. 8 is a cross-sectional side view of an IC device assembly 1700 that may include any of the microelectronic assemblies 100 disclosed herein. In some embodiments, the IC device assembly 1700 may be a microelectronic assembly 100. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any suitable ones of the embodiments of the microelectronic assemblies 100 disclosed herein.

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate. In some embodiments the circuit board 1702 may be, for example, a circuit board.

The IC device assembly 1700 illustrated in FIG. 8 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 8), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 8, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 1502 of FIG. 6), an IC device (e.g., the IC device 1600 of FIG. 7), or any other suitable component. Generally, the interposer 1704 may spread a connection to a wider pitch or reroute a connection to a different connection. For example, the interposer 1704 may couple the IC package 1720 (e.g., a die) to a set of ball grid array (BGA) conductive contacts of the coupling components 1716 for coupling to the circuit board 1702. In the embodiment illustrated in FIG. 8, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

In some embodiments, the interposer 1704 may be formed as a PCB, including multiple metal layers separated from one another by layers of dielectric material and interconnected by electrically conductive vias. In some embodiments, the interposer 1704 may be formed of an epoxy resin, a fiberglass-reinforced epoxy resin, an epoxy resin with inorganic fillers, a ceramic material, or a polymer material such as polyimide. In some embodiments, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 8 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 9 is a block diagram of an example electrical device 1800 that may include one or more of the microelectronic assemblies 100 disclosed herein. For example, any suitable ones of the components of the electrical device 1800 may include one or more of the IC device assemblies 1700, IC devices 1600, or dies 1502 disclosed herein, and may be arranged in any of the microelectronic assemblies 100 disclosed herein. A number of components are illustrated in FIG. 9 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 9, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (U MLS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a computing device or a hand-held, portable or mobile computing device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server, or other networked computing component, a printer, a scanner, a monitor, a set-top box, an entertainment control unit, a vehicle control unit, a digital camera, a digital video recorder, or a wearable computing device. In some embodiments, the electrical device 1800 may be any other electronic device that processes data.

The following paragraphs provide various examples of the embodiments disclosed herein.

Example 1 is a microelectronic assembly, including a substrate having a first surface and an opposing second surface, wherein a material of the substrate includes a glass material, and wherein the substrate includes a conductive through-glass via (TGV), and the second surface of the substrate includes a cavity; a first die at least partially nested in the cavity; an insulating material, on the second surface of the substrate, the insulating material having a first surface and an opposing second surface, wherein the first surface of the insulating material is at the second surface of the substrate; a first conductive pillar through the insulating material; a second conductive pillar through the insulating material; a capacitor in the insulating material at the second surface of the substrate, the capacitor including a first layer on the second surface of the substrate, the first layer including a conductive material electrically coupled to the TGV and the first conductive pillar, wherein the first layer forms a first plate of the capacitor; a second layer on the first layer, the second layer including a dielectric material; a third layer on the second layer, the second including the conductive material electrically coupled to the second conductive pillar, wherein the third layer forms a second plate of the capacitor; and a second die, at the second surface of the insulating material, electrically coupled to the first die.

Example 2 may include the subject matter of Example 1, and may further specify that an overall thickness of the capacitor is between 35 nanometers and 2,000 nanometers.

Example 3 may include the subject matter of Examples 1 or 2, and may further specify that a thickness of the first layer is between 10 nanometers and 15 microns and a thickness of the third layer is between 10 nanometers and 15 microns.

Example 4 may include the subject matter of any of Examples 1-3, and may further specify that the conductive material includes copper, silver, nickel, gold, aluminum, or alloys thereof.

Example 5 may include the subject matter of any of Examples 1-4, and may further specify that the first layer is a first conductive trace or a first conductive pad, and the third layer is a second conductive trace or a second conductive pad.

Example 6 may include the subject matter of any of Examples 1-5, and may further specify that a thickness of the second layer is between 10 nanometers and 250 nanometers.

Example 7 may include the subject matter of any of Examples 1-6, and may further specify that the dielectric material includes barium, titanium, and oxygen; strontium, titanium, and oxygen; titanium and oxygen; lead, zirconium, and titanium; barium, strontium, and titanium; a ferroelectric material; or a ferroelectric perovskite material.

Example 8 may include the subject matter of any of Examples 1-7, and may further specify that a thickness of the substrate is between 50 microns and 1,000 microns.

Example 9 may include the subject matter of any of Examples 1-8, and may further specify that the glass material of the substrate includes photoglass, borosilicate glass, soda lime glass, quartz, or a photoimageable glass.

Example 10 may include the subject matter of any of Examples 1-9, and may further specify that the capacitor is one of a plurality of capacitors.

Example 11 is a microelectronic assembly, including a substrate having a first surface and an opposing second surface, wherein a material of the substrate includes glass, and wherein the substrate includes a conductive through-substrate via (TGV), and the second surface of the substrate includes a cavity; a first die at least partially nested in the cavity; an insulating material, on the second surface of the substrate, the insulating material having a first surface and an opposing second surface, wherein the first surface of the insulating material is at the second surface of the substrate; a first conductive pillar through the insulating material; a second conductive pillar through the insulating material; a capacitor at the second surface of the substrate and embedded in the insulating material, the capacitor including a first conductive trace on the second surface of the substrate, the first conductive trace electrically coupled to the TGV and the first conductive pillar, wherein the first conductive trace forms a first electrode of the capacitor; a dielectric material on the first conductive trace; a second conductive trace on the dielectric material, the second conductive trace electrically coupled to the second conductive pillar, wherein the second conductive trace forms a second electrode of the capacitor; and a second die, at the second surface of the insulating material, electrically coupled to the first die.

Example 12 may include the subject matter of Example 11, and may further specify that the first conductive pillar and the second conductive pillar are further electrically coupled to the second die.

Example 13 may include the subject matter of Examples 11 or 12, and may further specify that the first die includes first conductive contacts on a first surface, second conductive contacts on an opposing second surface, and the second die is electrically coupled to the first die by the second conductive contacts, and microelectronic assembly further includes a small TGV electrically coupled to an individual one of the first conductive contacts on the first die; and a package substrate at the first surface of the substrate, the package substrate electrically coupled to the capacitor by the TGV and electrically coupled to the first die by the small TGV.

Example 14 may include the subject matter of Example 13, and may further specify that the TGV is one of a plurality of TGVs, and the microelectronic assembly and may further include a third conductive pillar extending through the insulating material, wherein the third conductive pillar is electrically coupled to an individual one of the plurality of TGVs, and wherein the package substrate is electrically coupled to the second die by the third conductive pillar and the individual one of the plurality of TGVs.

Example 15 may include the subject matter of any of Examples 11-14, and may further include a redistribution layer between the insulating material and the second die.

Example 16 may include the subject matter of any of Examples 11-15, and may further specify that the first die includes an embedded multi-die bridge (EMIB) die, a passive die, an EMIB with through-silicon vias (TSVs), or an active die.

Example 17 may include the subject matter of any of Examples 11-16, and may further specify that the second die includes a central processing unit (CPU), a graphics processing unit (GPU), or a processing die.

Example 18 may include the subject matter of any of Examples 11-17, and may further specify that the dielectric material includes barium, titanium, and oxygen; strontium, titanium, and oxygen; titanium and oxygen; lead, zirconium, and titanium; barium, strontium, and titanium; a ferroelectric material; or a ferroelectric perovskite material.

Example 19 is a method of manufacturing a microelectronic assembly, including forming a first opening through a glass substrate; depositing a conductive material in the first opening to form a through-glass substrate via (TGV); forming a first conductive layer, on the glass substrate, electrically coupled to the TGV; forming a dielectric material on the first conductive layer; forming a second conductive layer on the dielectric material; forming a second opening in the glass substrate; placing a first die in the second opening; forming an insulating material on the glass substrate, on and around the first die, and on and around the first conductive layer, the dielectric material, and the second conductive layer; forming a first conductive pillar through the insulating material electrically coupled to the first conductive layer; forming a second conductive pillar through the insulating material electrically coupled to the second conductive layer, placing a second die on the insulating material; and forming an interconnect between the first and second dies.

Example 20 may include the subject matter of Example 19, and may further specify that the interconnect is a first interconnect, and the method and may further include forming second interconnects between the TGV and a package substrate.

Example 21 may include the subject matter of Examples 18 or 19, and may further include forming a redistribution layer on the insulating material before placing the second die.

Example 22 is a microelectronic assembly, including a substrate having a first surface and an opposing second surface, wherein a material of the substrate includes a glass material, and wherein the substrate includes a conductive through-glass via (TGV), and the second surface of the substrate includes a cavity; a first die at least partially nested in the cavity; an insulating material, on the second surface of the substrate, the insulating material having a first surface and an opposing second surface, wherein the first surface of the insulating material is at the second surface of the substrate; a first conductive pillar through the insulating material; a second conductive pillar through the insulating material; a capacitor in the insulating material at the second surface of the substrate, the capacitor including a first layer on the second surface of the substrate, the first layer including a conductive material electrically coupled to the TGV and the first conductive pillar, wherein the first layer forms a first plate of the capacitor; a second layer on the first layer, the second layer including a dielectric material, wherein the dielectric material includes at least one of barium, strontium, and titanium; a third layer on the second layer, the second including the conductive material electrically coupled to the second conductive pillar, wherein the third layer forms a second plate of the capacitor; and a second die, at the second surface of the insulating material, electrically coupled to the first die.

Example 23 may include the subject matter of Example 22, and may further specify that the dielectric material includes barium, titanium, and oxygen; strontium, titanium, and oxygen; titanium and oxygen; lead, zirconium, and titanium; barium, strontium, and titanium; a ferroelectric material; or a ferroelectric perovskite material.

## Claims

1. A microelectronic assembly, comprising:
a substrate having a first surface and an opposing second surface, wherein a material of the substrate includes a glass material, and wherein the substrate includes a conductive through-glass via (TGV), and the second surface of the substrate includes a cavity;
a first die at least partially nested in the cavity;
an insulating material, on the second surface of the substrate, the insulating material having a first surface and an opposing second surface, wherein the first surface of the insulating material is at the second surface of the substrate;
a first conductive pillar through the insulating material;
a second conductive pillar through the insulating material;
a capacitor in the insulating material at the second surface of the substrate, the capacitor including:
a first layer on the second surface of the substrate, the first layer including a conductive material electrically coupled to the TGV and the first conductive pillar, wherein the first layer forms a first plate of the capacitor;
a second layer on the first layer, the second layer including a dielectric material;
a third layer on the second layer, the second including the conductive material electrically coupled to the second conductive pillar, wherein the third layer forms a second plate of the capacitor; and
a second die, at the second surface of the insulating material, electrically coupled to the first die.

2. The microelectronic assembly of claim 1, wherein an overall thickness of the capacitor is between 35 nanometers and 2,000 nanometers.

3. The microelectronic assembly of claim 1 or 2, wherein a thickness of the first layer is between 10 nanometers and 15 microns and a thickness of the third layer is between 10 nanometers and 15 microns.

4. The microelectronic assembly of any one of claims 1-3, wherein the conductive material includes copper, silver, nickel, gold, aluminum, or alloys thereof.

5. The microelectronic assembly of any one of claims 1-4, wherein the first layer is a first conductive trace or a first conductive pad, and the third layer is a second conductive trace or a second conductive pad.

6. The microelectronic assembly of any one of claims 1-5, wherein a thickness of the second layer is between 10 nanometers and 250 nanometers.

7. The microelectronic assembly of any one of claims 1-6, wherein the dielectric material includes barium, titanium, and oxygen; strontium, titanium, and oxygen; titanium and oxygen; lead, zirconium, and titanium; barium, strontium, and titanium; a ferroelectric material; or a ferroelectric perovskite material.

8. The microelectronic assembly of any one of claims 1-7, wherein a thickness of the substrate is between 50 microns and 1,000 microns.

9. The microelectronic assembly of any one of claims 1-8, wherein the glass material of the substrate includes photoglass, borosilicate glass, soda lime glass, quartz, or a photoimageable glass.

10. The microelectronic assembly of any one of claims 1-9, wherein the first conductive pillar and the second conductive pillar are further electrically coupled to the second die.

11. The microelectronic assembly of any one of claims 1-10, wherein the first die includes first conductive contacts on a first surface, second conductive contacts on an opposing second surface, and the second die is electrically coupled to the first die by the second conductive contacts, and microelectronic assembly further comprises:
a small TGV electrically coupled to an individual one of the first conductive contacts on the first die; and
a package substrate at the first surface of the substrate, the package substrate electrically coupled to the capacitor by the TGV and electrically coupled to the first die by the small TGV.

12. The microelectronic assembly of claim 11, wherein the TGV is one of a plurality of TGVs, and the microelectronic assembly further comprising:
a third conductive pillar extending through the insulating material, wherein the third conductive pillar is electrically coupled to an individual one of the plurality of TGVs, and
wherein the package substrate is electrically coupled to the second die by the third conductive pillar and the individual one of the plurality of TGVs.

13. The microelectronic assembly of any one of claims 1-12, further comprising:
a redistribution layer between the insulating material and the second die.

14. A method of manufacturing a microelectronic assembly, comprising:
forming a first opening through a glass substrate;
depositing a conductive material in the first opening to form a through-glass substrate via (TGV);
forming a first conductive layer, on the glass substrate, electrically coupled to the TGV;
forming a dielectric material on the first conductive layer;
forming a second conductive layer on the dielectric material;
forming a second opening in the glass substrate;
placing a first die in the second opening;
forming an insulating material on the glass substrate, on and around the first die, and on and around the first conductive layer, the dielectric material, and the second conductive layer;
forming a first conductive pillar through the insulating material electrically coupled to the first conductive layer;
forming a second conductive pillar through the insulating material electrically coupled to the second conductive layer,
placing a second die on the insulating material; and
forming an interconnect between the first and second dies.

15. The method of claim 14, wherein the interconnect is a first interconnect, and the method further comprising:
forming second interconnects between the TGV and a package substrate.
